# EUROPEAN PATENT APPLICATION

(11) **EP 1 605 378 A1**
(43) Date of publication of application: **14.12.2005**
(21) Application number: 05012223.3
(22) Date of filing: 07.06.2005
(51) Int. Cl.: G06F 17/50

(54) **Method for generating hardware information**

(30) Priority: 07.06.2004 US 862801
(71) Applicant: IP Flex Inc., Tokyo 141-0021 (JP); Celoxica Limited, Abingdon, Oxon OX14 4RX (GB)
(72) Inventor: Mulholland, Philip John, Tokyo 152-0031 (JP); Garner, Robert E., Austin TX 78739 (US)
(74) Representative: Körber, Martin Hans

(57) **Abstract**

A method is provided that generates hardware information for executing a first program including a first algorithm that repeats a first process, the hardware information being suited to implementing a "for" loop written in C language in a device in which a plurality of PE are connected and a circuit can be dynamically reconfigured, the method comprising generation of:
(a) first configuration information for generating output data produced by executing the first process on input data;
(b) second configuration information for executing a process that loads the input data from a first memory using a first address counter;
(c) third configuration information for executing a process that stores the output data in a second memory using a second address counter;
(d) fourth configuration information for executing a process that loads the input data from an external memory into the first memory using a third address counter; and
(e) fifth configuration information for executing a process that stores the output data in an external memory from the second memory using a fourth address counter.

## Description

### BACKGROUND OF THE INVENTION

### TECHNICAL FIELD

The present invention relates to the configuration of an integrated circuit for executing a specification provided in a high-level language such as C and to the designing of such an integrated circuit.

### DESCRIPTION OF THE RELATED ART

As methods of executing an intended algorithm using hardware, there is a first method in which a general-purpose processor, such as a standard processor, is operated by software to realize the intended algorithm and a second method in which special-purpose circuitry equipped with a data path for executing the intended algorithm is used. The first method has an advantage in that a software engineer can easily have the intended algorithm executed, but the execution speed is greatly affected by processor performance. Also, since general-purpose hardware is used, there are many cases where the scale and cost of the hardware are not economical for executing the intended algorithm. Since special-purpose hardware is used, the second method can achieve a sufficient processing speed with relatively simple hardware, so that the scale of the hardware is economical. However, a large cost and much time are required to develop special-purpose hardware. In particular, special-purpose circuitry cannot be developed by software engineers alone, and since hardware engineers are also required, labor expenses are very high. This means that while the second method has the benefit of being economical for executing the intended algorithm, it is very dependent on the extent to which the special-purpose hardware can be mass produced.

On the hardware side, devices such as FPGA whose circuit configuration can be changed after manufacturing have been provided in recent years. FPGA include redundant part, and so are not the exact equivalent of specially developed hardware in terms of performance and scale. Anyhow, FPGAs make it possible to obtain hardware with almost equivalent performance to special-purpose circuitry in a short time. However, to produce an FPGA, fundamentally the same amount of circuit information is generated as when designing special-purpose circuitry and this information is then implemented or loaded in the FPGA, so that many aspects depend on the ability of hardware engineers.

Hardware that can use a single device to execute a plurality of applications or algorithms by switching the circuit configuration at high speed has also been developed. One example of a device that can be dynamically reconfigured is the device disclosed by US Patent Publication 2003/0184339 in which processing elements are arranged in a matrix.

On the software side, tools (compilers) for automatically converting a specification provided in a high-level programming language such as C into a hardware description language such as RTL, and C language that is capable of hardware description are being developed. Accordingly, it is starting to become possible for software engineers to handle the designing of hardware, and coupled with the reconfigurable hardware described above, it is believed that the time and cost required to design and develop hardware for executing an intended algorithm will be greatly reduced in the future.

However, in the process of designing hardware from a current high-level programming language, the method of converting or implementing the algorithm into a data path merely follows the method used in the process of designing and developing a special-purpose circuit such as a conventional ASIC, and so has not kept pace with advances in hardware. For example, a conventional special-purpose circuit is realized by a combination of a data path that carries out processing in accordance with the intended algorithm and a state machine that controls the data path. In an FPGA, although the circuits cannot be dynamically reconfigured, it is possible to implement a circuit at the transistor level. Accordingly, with an FPGA, no major difficulties have been identified for implementing the same configuration as a conventional special-purpose circuit, and no attempts have been made to verify whether the combination of a data path and a state machine is actually the best solution.

On the other hand, many devices in which circuits can be dynamically reconfigured use a technique where data paths are realized by connecting processing elements (PE) that are equipped with a certain level of computational performance like ALU, with the data paths being implemented by connecting a number of PEs spread out in a matrix. To carry out overall control of this kind of data path using a state machine constructed in a different region inside the matrix, PEs are consumed in constructing the state machine and wiring resources are consumed to connect the state machine and the data path. This means that the use of a combination of the data path and a state machine can cause a reduction in implementation efficiency and also a drop in AC characteristics.

In a device in which a general-purpose processor, such as a RISC, is combined with hardware in which data paths can be reconfigured, processing that is repeatedly executed should preferably be converted into a data path and executed using the reconfigurable hardware. Accordingly, out of an algorithm written in C language, a repeated process such as a "for" loop should preferably be executed after being converted into a data path. In addition, the processing speed can be further improved if it is possible to carry out a plurality of repeated processes in parallel. However, the hardware resources for constructing the data paths are limited. Also, if the number of PE is increased irresponsibly, the device becomes less economical and there is also a drop in AC characteristics, so that such increases are not advantageous.

For this reason, the present invention provides a configuration suited to executing repeated processing in a reconfigurable device including a plurality of PE that have a certain level of computational processing performance. This hardware configuration is generated for implementing an algorithm of repeated processing in hardware, and is provided as a method, a compiler, and a program product that automatically generates hardware information that include the hardware configuration from an algorithm with repeated processing. In addition, hardware information that is loaded into a reconfigurable device to generate a construction that executes repeated processing is provided having been recorded on a suitable recording medium.

### SUMMARY OF THE INVENTION

A method for generating hardware information for executing a first program that includes a first algorithm that repeats a first process is provided in this invention. The method comprises generation of:
(a) first configuration information for generating output data produced by executing the first process on input data;
(b) second configuration information for executing a process that loads the input data from a first memory using a first address counter; and
(c) third configuration information for executing a process that stores the output data in a second memory using a second address counter.
   When a "for" loop written in C language is implemented in a special-purpose circuit, a data path is generated for executing a first process inside the loop, a state machine controlled by a loop counter is generated, and the data path is controlled by the state machine. With such a construction, it is possible to control a data path with a single loop counter, so that a conventional special-purpose circuit can be realized with fewer hardware resources, which means such implementation method for conventional special-purpose circuit is efficient on a conventional special-purpose circuit. However, as previously described, for a device where a plurality of PE are connected to form a circuit that is dynamically reconfigured, such implementation method for conventional special-purpose circuit leads to increased consumption of PE (Processing Element) resources and wiring resources, and is not favorable.
   The repeated processing is also executed by converting a first process inside a loop to a data path that carries out an input/output process for memory and having an address counter control input data and output data for the data path. By controlling the loading of the input data using a first address counter and controlling the storing of output data by a second address counter, it is possible to control the flow of data in the data path, so that there is no need to control the data path using a sequencer. Therefore, when the hardware information according to the present invention is applied, in place of the single loop counter, at least two address counters are required, so that there is an increase in the number of counters. There is also an increase in at least the first memory for storing input data and the second memory for storing output data.
   However, by using the hardware information of this invention, first, the respective address counters respectively control input and output, so that the circuit arrangement becomes simple, and it is possible to configure the address counters near or inside the PE that inputs and near or inside the PE that outputs respectively. Accordingly, the consumption of PEs and wiring resources can be reduced and the control of PEs is distributed so that a drop in the AC characteristics can be avoided. In addition, by positioning the counters inside or next to a PE that controls input and output respectively, it becomes easy to solve the problem of timing closure and the place and route process, which generates the hardware information for configuring the reconfigurable region, can be carried out at high speed.
   With a special-purpose circuit, there is an increase in the amount of circuits for counters whenever an additional repeated process is converted to a circuit. However, with the reconfigurable device, the resources that configure the counter are part of the resources that are reconfigurable for other processing or another repeated process, so that the increasing of counters per a repeated process dose not create a requirement of a large increase in hardware resources.
   The increasing of memory for storing the input data and output data has the same solution. With the hardware arrangement provided by the present invention, although there is an increase in memory used for a repeated process, such memory is part of the resources used for other processing or another repeated process, so that this does not cause a large increase in hardware resources and does not present a problem for increasing the usage efficiency.
   The hardware information according to the present invention includes the first configuration information, the second configuration information and the third configuration information and the hardware information can also be used to design a special-purpose circuit. However, as described above, the hardware information of the present invention is information suited to changing at least part of the configuration of an integrated circuit device with a reconfigurable region. Accordingly, it is preferable to supply the hardware information recorded on a suitable recording medium such as a ROM and to have software that controls the integrated circuit device load the hardware information into a configuration memory or a circuit that controls the reconfigurable region with appropriate timing and then use the hardware information for executing the first algorithm that repeats the first process.
   Here, when the reconfigurable region includes a plurality of processing elements (PE), the first configuration information should preferably include information for configuring a pipeline using at least some of the plurality of processing elements. While the hardware information of the present invention can also be effectively applied in a data flow-type integrated circuit device in which the function of PEs is fired by only control of token, for an integrated circuit device in which the PE operate in synchronization with a clock signal, by constructing a pipeline using the first configuration information, it is possible to carry out the first process inside the loop with pipeline processing and to reduce the processing time.
   In the hardware information for the reconfigurable integrated circuit device, to arrange a counter using reconfigurable resources, the second configuration information and the third configuration information should preferably include information for configuring the first address counter and the second address counter using at least some of the plurality of processing elements.
   Compared to a reconfigurable integrated circuit device equipped with a plurality of general-purpose processing elements, a reconfigurable integrated circuit device equipped with a plurality of types of processing elements that to a certain extent are dedicated to various types of processing is more flexible, has high implementation efficiency, and has favorable AC characteristics. When the processing elements include special-purpose elements including an address generating circuit and being suited to the process that loads and/or the process that stores, the second configuration information and the third configuration information should preferably include information that arrange the first address counter and the second address counter so as to include such special-purpose elements respectively.
   While the first memory and second memory that store input/output data may be an external memory for an integrated circuit device, when the first memory and the second memory are internal buffers, the first and second memories will be caches, so that the input/output speed for the data path arranged by the first configuration information can be improved and the processing speed can also be improved. The internal buffer may be a memory for a cache, and some processing elements may include function of RAM. In this case, it is necessary to input and output data to and from the internal buffers from the external memory, so that the configuration information below should preferably be generated for generating the hardware information that includes the information below:
(d) fourth configuration information for executing a process that loads the input data from an external memory into the first memory using a third address counter; and
(e) fifth configuration information for executing a process that stores the output data in an external memory from the second memory using a fourth address counter.

By additionally providing another address counters to control inputs and outputs to and from an external memory, it is possible to distribute and arrange the counters so that the wiring resources can be saved and the place and route process for generating the hardware information can be carried out at high speed.

If the first memory and the second memory are a double buffered type, the fourth information should preferably include configuration information for realizing a process that loads input data coordinating with swapping of the first memory, and the fifth information should preferably include configuration information for realizing a process that stores input data coordinating with swapping of the second memory. Using such configurations, even if a large amount of data is processed by the repeated process, the process of inputting and outputting data from the external memory into the internal buffer is prevented from becoming an overhead.

When the first process that is repeatedly executed using a loop index, the first configuration information may include information that arranges a counter that counts a loop index. If the first configuration information includes configuration information for realizing a process that generates parameters based on a value of a first address counter and/or a second address counter, a counter for counting the loop index can be omitted.

When the first program includes a second algorithm that repeats a process including a first algorithm, although it is possible to cope by providing multiple address counters and carrying out multiple inputs and outputs, it is not preferable to increase the number of inputs and outputs. Accordingly, the second configuration information and the third configuration information should preferably include configuration information for realizing processing that includes the second algorithm so as to control the multiple loops by combined address counters.

In addition, if the first configuration information includes configuration information for executing processing in the second algorithm and aside from the first process at appropriate timing, processing in the second algorithm and aside from the first process can be incorporated into the data path that carries out the repeated process. Accordingly, the data path construction can be simplified and the amount of PE resources and wiring resources consumed can be reduced.

This method that generates the above hardware information can be provided as a program product for having a computer carry out a process that generates the hardware information including the above configuration information. Such program can be provided having been recorded on a suitable recording medium such as a CD-ROM, and can also be provided via a computer network such as the Internet. This means that by loading a program into a computer equipped with suitable hardware resources, it is possible to use the computer as a compiler that has means for generating hardware information including the configuration information described above for executing the first program that includes the first algorithm for repeating the first process.

### BRIEF DESCRIPTION OF THE DRAWINGS

In the drawings:
FIG. 1 is a diagram schematically showing a processing unit (PU);
FIG. 2 shows example of a type of processing elements (PE);
FIG. 3 shows another type of PE suited to generating addresses;
FIG. 4 shows an address generating circuit of the data path part shown in FIG. 3;
FIG. 5 shows a counter in FIG. 4;
FIG. 6 is a diagram schematically showing a system that generates hardware information;
FIG. 7 is a diagram schematically showing processing of a compiler;
FIG. 8 is a diagram showing one example of a source program;
FIG. 9 shows an example implementation that uses a state machine;
FIG. 10 shows an example implementation for the PU shown in FIG. 1;
FIG. 11 shows another example of a source program; and
FIG. 12 shows yet another example of a source program.

### DESCRIPTION OF THE PREFERRED EMBODIMENT

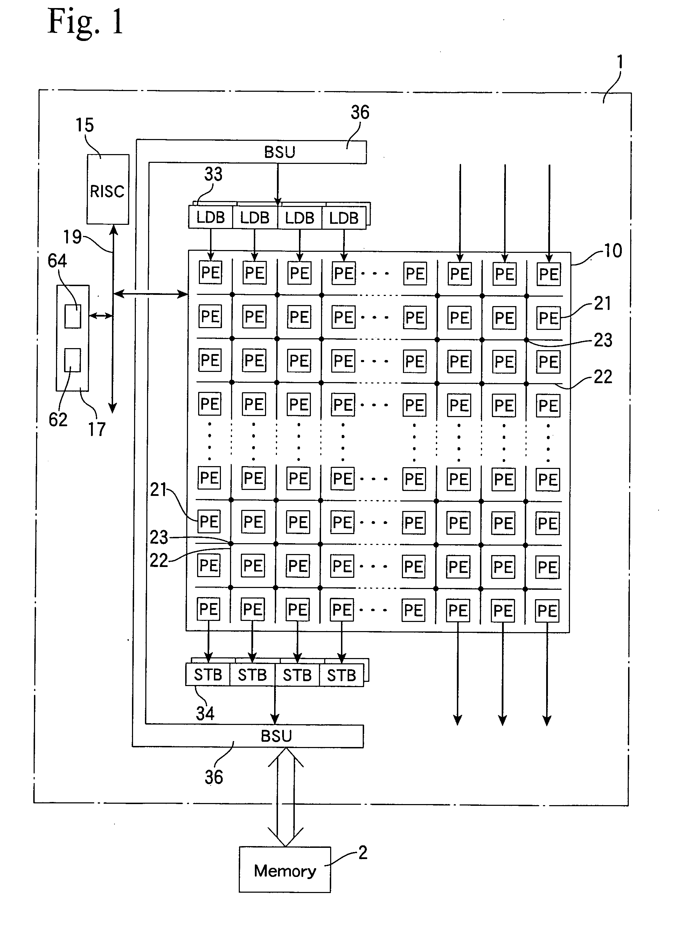

FIG. 1 shows one example of a data processing device. This data processing device 1 is a processing unit (PU) integrated on a chip, and includes a reconfigurable region 10, a general-purpose processor (hereinafter simply "processor") 15, such as a RISC, with a function for reconfiguring the reconfigurable region 10, and a memory 17 that stores a program 64 of the processor 15 and hardware information 62 for reconfiguring the reconfigurable region 10. A plurality of elements are two-dimensionally arranged in an array or matrix in the reconfigurable circuit region 10, which is a construction hereinafter called the "matrix". The matrix 10 includes a plurality of processing elements (PE) 21 disposed in two dimensions vertically and horizontally, wires 22 that are disposed in a lattice between the processing elements 21, and a switching unit 23 that can freely switch the connections between the vertical and horizontal wires at connection points of the wires 22.

The PE 21 may be elements whose functions can be freely set using a look up table or the like. In the present embodiment, the space efficiency of the matrix 10 is improved by dividing the elements into functional groups roughly, such as elements for arithmetic and logical operations, elements for delaying, elements for memory, elements for issuing or generating addresses for inputting or outputting data, elements for inputting or outputting data, and the like, and disposing elements with internal circuitry suited to the respective functions and processing in such groups. Also, by arranging the elements in generalized functional groups, there is a reduction in redundancy and the merit that the AC characteristics and processing speed can be improved.

The matrix 10 of the PU 1 includes 368 PE 21, and under the control of the processor 15, configuration data for controlling the functions of the individual PE 21 and the connections of the wires 22 is supplied via a control bus 19 from the processor 15 or from the memory 17. Accordingly, the PE 21 can be flexibly connected by the wires 22, and a variety of data flows (data paths) can be freely arranged.

As another input system, the PU 1 further includes a system that supplies data to the matrix 10 using an input buffer 33 and an output buffer 34. The input buffer 33 includes four input buffer elements LDB, with it being possible to set the configuration and control of the input buffer 33 via the configuration data. In the same way, the output buffer 34 includes four output buffer elements STB. The input buffer 33 and the output buffer 34 are connected to a bus switching unit (a bus interface or "BSU") 36 that functions as an access arbitration unit, with it being possible to input and output data to and from an external memory 2 via the BSU 36. The respective input buffer elements LDB and the respective output buffer elements STB are a double buffered type that each includes two buffer units. One of such buffer elements is an input buffer that inputs data while the other buffer element is an output buffer that outputs data, and when data to be outputted from the output buffer is outputted, the two buffer units are swapped so that the output buffer and the input buffer are interchanged.

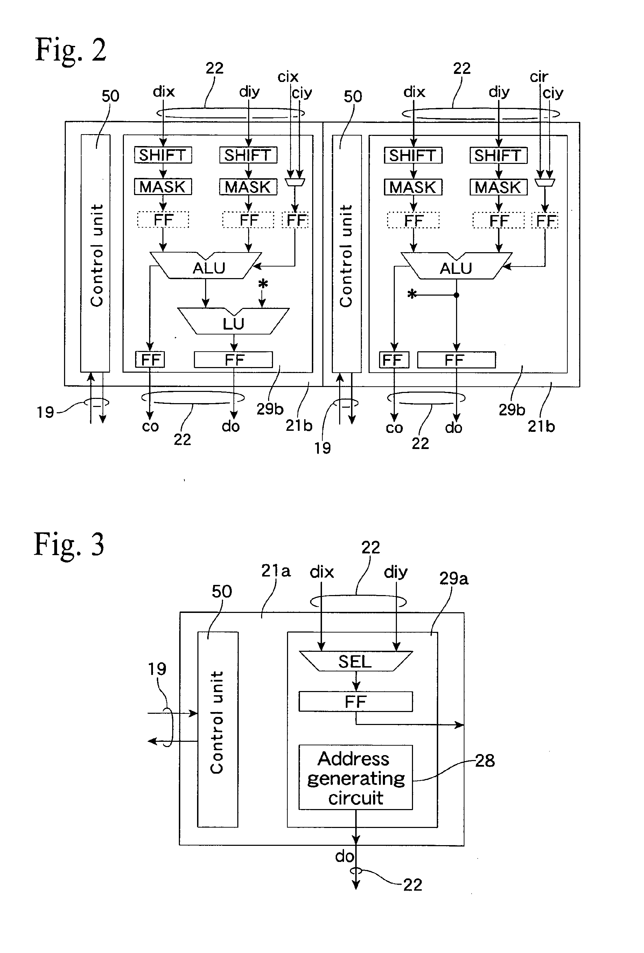

FIG. 2 shows example of a type of PE 21. These PE 21 include respectively an internal data path region 29 whose function can be changed and a control unit 50 that sets the function of the internal data path region 29. These PE 21b shown in FIG. 2 are computational PE with a construction suited to arithmetic operations and logic operations. The respective internal data path regions 29b include a shift circuit SHIFT, a mask circuit MASK, and an arithmetic logic unit ALU. Each control unit 50 receives the configuration data from the processor 15 via the control bus 19 and controls the internal data path region 29b. In the same way as other PE, the PE 21b includes a selector (not shown) for selecting input data from one of the wires included in the wire group 22 and for also outputting output data, with such settings being made by the control unit 50 based on the configuration data. Accordingly, in the PE 21b, the conditions of the shift circuit SHIFT, the mask circuit MASK, and the arithmetic logic unit ALU can be set by the control unit 50, the selected input data dix and diy can be added or subtracted, compared, or subjected to a logical AND or a logical OR, and the result can be outputted to a selected wire (bus) 22 as an output signal do.

The PE 21a shown in FIG. 3 is an element equipped with a function for controlling the inputting and outputting of data to and from the buffers 33 and 34. An internal data path region 29a of the PE 21a includes an address generating circuit 28 composed of a counter or the like, and a selector SEL, and in accordance with the configuration data set by the control unit 50, an address for controlling inputs and outputs is generated and outputted to the wires 22 as the output signal do. This output signal do is fed back into the PE 21a as the input signal dix or diy via the row wires and column wires either in the output state or after processing by other PE 21. The PE 21a also outputs an address selected by the selector SEL according to conditions set by the control unit 50 from the matrix 10 as a data input or data output address.

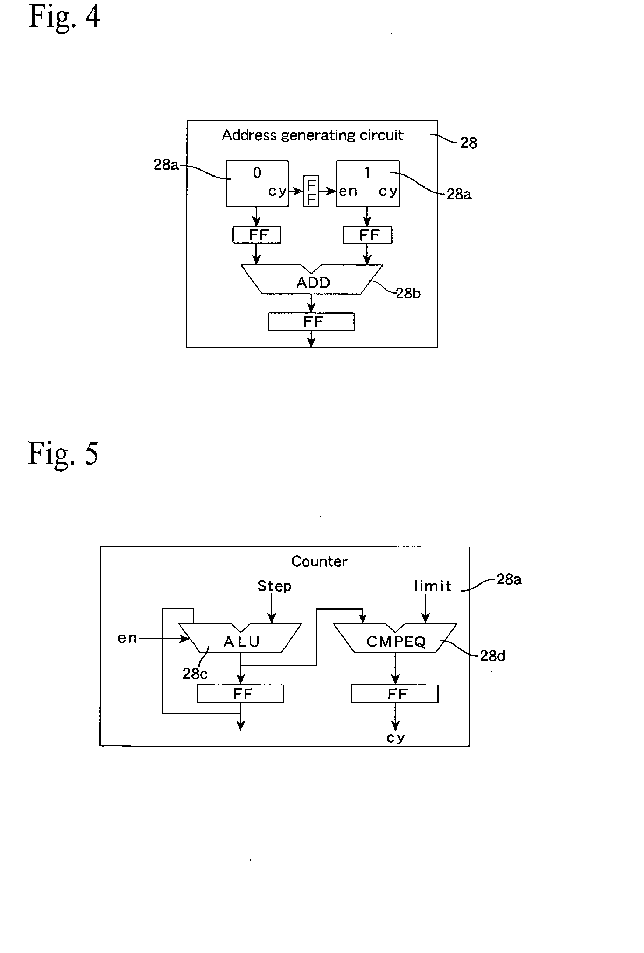

FIG. 4 shows an example of an address generating circuit 28. This address generating circuit 28 includes a plurality of counters 28a and an adder 28b that carries out an operation on the output of the counters 28a and outputs the result as an address. As shown in FIG. 5, the respective counters 28a are composed of a combination of an arithmetic logic unit ALU 28c and a comparator 28d, with it being possible to set the ALU 28c to carry out an ADD, SUB, BIT SHIFT, OR, or XOR operation or a combination of such processes. Accordingly, the address generating circuit 28 functions as a function generating circuit that issues a value whenever a clock arrives, with it being possible to set the function of the counters 28a from the processor 15 via the control unit 50.

A control signal en of the ALU 28c is set by a carry signal cy supplied from another counter 28a and the output of the comparator 28d can be transmitted to another counter 28a as the carry signal cy. By using carry signals in this way, the state of a counter 28a can be set by the state of another counter 28a to have an arbitrary address issued. In addition, although not shown in the figures attached to this specification, the control signal en of the counter 28a can be set by a carry signal cy supplied from another PE 21 and can also be transmitted to another PE 21.

Accordingly, the processing content of address generation by the PE 21a that outputs an address can be freely set by configuration data supplied to the control unit 50 from the processor 15, and the relationship with other PE 21 can also be freely set. Also, two types of PE 21a that issue addresses are provided. One type is a PE that issues an address that controls inputs and outputs of data between the external memory 2 and the internal buffers 33 and 34 that are the local buffers, with this PE including a 32-bit counter and supplying an address signal to the BSU 36 and input buffer 33 or the output buffer 34. The other type is a PE that issues an address that controls inputs and outputs of data between the internal buffers 33 and 34 and the matrix 10, with this PE including a 16-bit counter and supplying an address signal to the internal buffer 33 or 34, and to a PE 21 that inputs data from the input buffer 33 or a PE 21 that outputs data to the internal buffer 34.

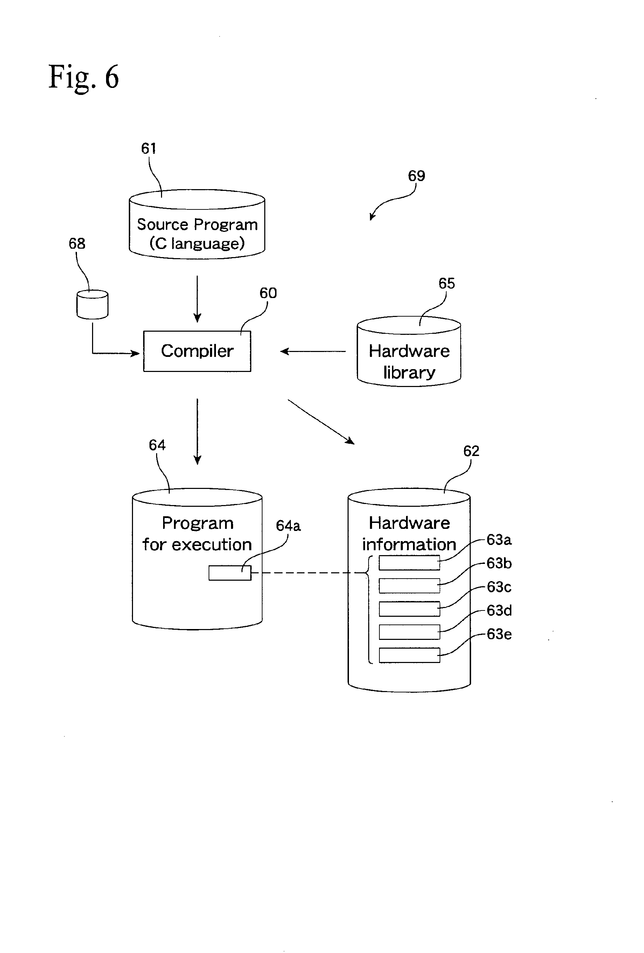

FIG. 6 schematically shows a system 69 that outputs hardware information using the present invention. A specification (source program) 61 provided in C language is inputted into the compiler 60. Hardware information 62 for configuring hardware suited to execution of the source program 61 and a program 64 to be executed on this hardware to control the hardware are outputted from the compiler 60. At this stage, the program 64 for execution may be a program or code that can be directly executed by the intended hardware, or may be a program in an intermediate language that has been converted to a content suited to the intended hardware. To make it possible for the hardware to directly execute an execution program provided in an intermediate language, it may be necessary to convert the execution program to machine language. To generate such outputs 62 and 64, the compiler 60 refers to a hardware library 65 that stores information on hardware resources that can be used to execute the source program 61. In this embodiment, information of the hardware resources of the PU 1 equipped with a dynamically reconfigurable region is stored in the hardware library 65. As examples, such information can include types and numbers of the PE 21, processing executable by the respective PE 21 and the number of clocks (latency) used by such processing, and the amount and connectable range of the wires 22.

The system 69 can be constructed using a standard computer equipped with suitable hardware resources, and software (a program product) 68 for causing such computer to function as the compiler 60 may be supplied having been recorded on a suitable recording medium such as a CD-ROM and then loaded with suitable timing. The program 68 can also be provided via a computer network, such as the Internet. Also, the input/output data including the source program 61, the hardware library 65, the hardware information 62 and the program for execution 64 may also be inputted and outputted via a recording apparatus of the system 69, or may be inputted and outputted to or from another server via a computer network.

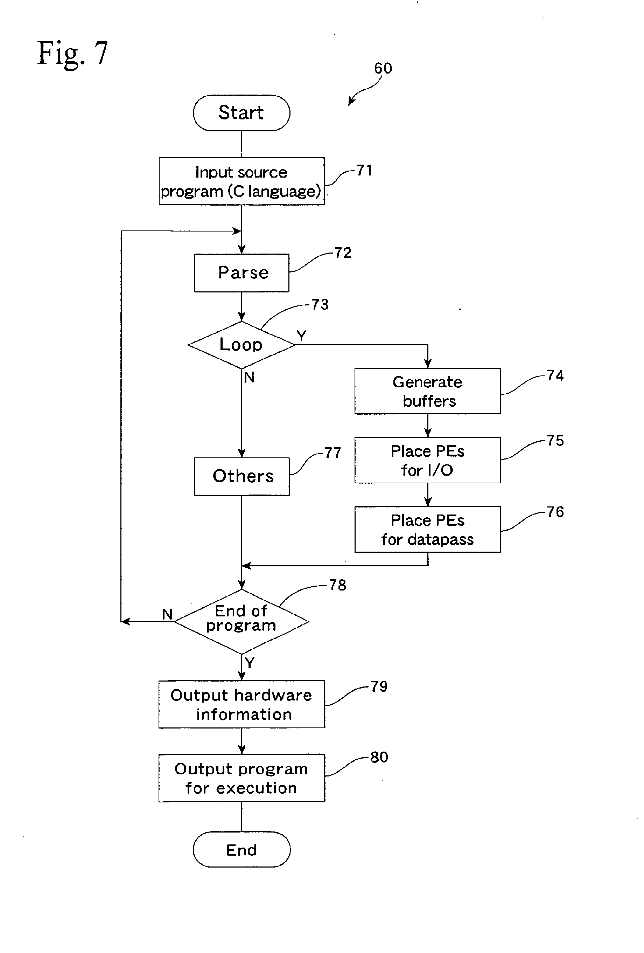

FIG. 7 is a flowchart schematically showing the processing of the compiler 60. First, in step 71, the source program 61 written in C language or another high-level programming language is read, and then in step 72, the program 61 is parsed. In step 73, during the parse of the algorithm described in the program 61, when it is judged that a part of the algorithm is a loop process where a specified process (a first process) is repeatedly carried out, in step 74, the input buffer and the output buffer are reserved corresponding to the description of the part of algorithm (a first algorithm) for carrying out this loop process. Also, in step 75, PE 21a equipped with address counters that carry out input/output processing for these buffers are respectively reserved. Accordingly, at this stage, second configuration information 63b for executing a process that loads input data from a first memory (buffer) using a first address counter and third configuration information 63c for executing a process that stores output data in the second memory (buffer) using a second address counter are generated.

In addition, when it is necessary to control inputting and outputting between the buffers and the external memory, fourth configuration information 63d for executing a process that loads input data from the external memory into the first memory using a third address counter and fifth configuration information 63e for executing a process that stores output data in the external memory from the second memory using a fourth address counter are generated.

Next, in step 76, after or simultaneously with steps 74 and 75, a data path for executing the first process that is carried out repeatedly in the first algorithm is generated as a combination of the PE 21 and the wires 22, and configuration information (the first configuration information) 63a including the arrangement of these PE 21 is generated. During execution of the program 64, it is necessary for the first to third configuration information to be loaded into the matrix 10 at suitable timing. For this reason, a statement 64a that is an interface for providing the processor 15 with the timing for loading is generated and is included in the program 64 for execution.

In step 77 it is determined whether it is suitable to have processing aside from the loop process of the source program 61 executed by the matrix 10 or by the processor 15. Configuration information that uses PE21 is generated for processing that is advantageously executed by a data path using the PE 21. The description of processing that should preferably be executed in the processor 15 is converted to executable code for the processor 15.

In step 78, when the parsing of the program 61 and the conversion to the hardware information 62 and the program for execution 64 are completed, in steps 79 and 80, the hardware information 62 and the execution program 64 are outputted. The hardware information 62 and the execution program 64 are subjected to various optimizations at a stage before output or during generation. Although being not described in detail, the hardware information 62 is finally outputted after the generated configuration information for the matrix 10 undergoes a variety of processes such as optimization of the assigning of hardware resources and verification of timing closure by carrying out place and route. In addition, operations are verified for the outputted hardware information 62 and the execution program 64 by a simulation, and further optimization is carried out.

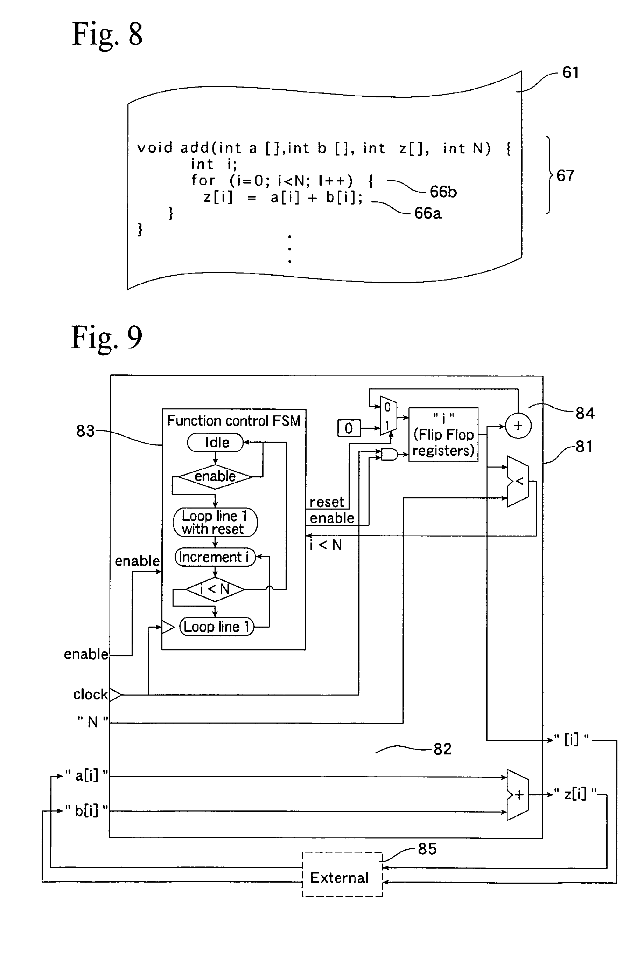

FIG. 8 shows one example of a source program 61. This program 61 includes a loop process 67 in which a process 66a that adds variables a[i] and b[i] to generate a variable z[i] is repeated N times. For reference purposes, FIG. 9 shows an example where the loop process 67 is implemented in an FPGA or the like by a hardware macro 81. In this hardware macro 81, a data path 82 that carries out an addition 66a and a state machine 83 that controls the data path 82 by counting with a loop counter 84 are implemented. Also, an input/output process 85 for variables is delegated to special-purpose hardware, such as a memory managing unit.

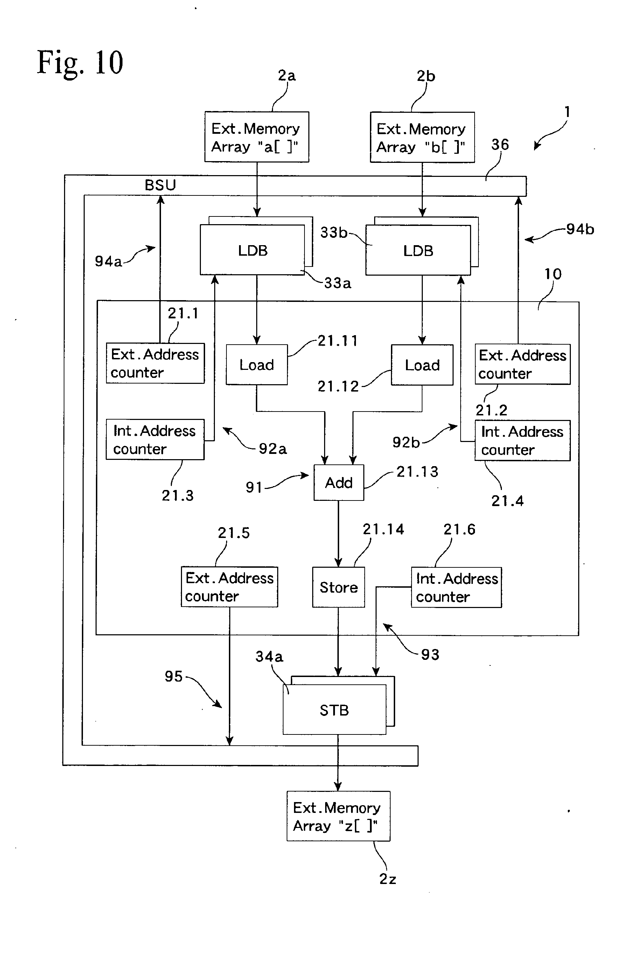

FIG. 10 schematically shows an arrangement of the PU 1 that has been reconfigured by the hardware information 62 generated by the compiler 60 from the source program 61 shown in FIG. 8. First, according to the first configuration information 63a generated corresponding to the statement 66a that defines the repeatedly executing process in the algorithm 67 of the loop process in the program 61, a data stream (data path) 91 having a form of inputting and outputting data to and from the buffers is configured in the matrix 10 by PE 21.11 to PE 21.14. For the PE 21.13 that carries out an addition, a PE 21b for arithmetic and logic operations shown in FIG. 2 is assignable. For the PE 21.11 and others that input and output data, the PE 21b for arithmetic and logic operations is also assignable, but it is also possible to provide different PE of a type that is dedicated to inputting and outputting data using components like flip-flops.

Next, the buffers 33a and 33b that store the respective input data a[i] and b[i] are assigned by the second configuration information 63b generated corresponding to the statement 66b that defines the iteration of the algorithm 67 of the loop process. Also, functions 92a and 92b that supply internal input addresses to the buffers 33a and 33b and input the input data into the data path 91 are configured mainly using PE 21.3 and PE 21.4. The second configuration information 63b includes not only an assignment of the PE 21 but also other information necessary for inputting and outputting of signals, such as internal settings of the PE 21 and wiring information to the address outputting, but the description here will focus on the selection of the PE 21. This is also the same for the other configuration information.

PE 21a shown in FIG. 4 having address generating function can be assigned for the PE 21.3 and 21.4 that are used as the internal address counter. A configuration of combination of the PE 21b for logic operations is also usable for internal address counter, but in the matrix 10, the PE 21a are provided for generating address so that the arrangement using such elements is economical.

An output buffer 34a that stores the output data z[i] is assigned and a function 93 that supplies an internal output address to the buffer 34a and outputs processed data from the data path 91 is arranged using mainly PE 21.6 by the third configuration information 63c generated together with the second configuration information 63b. In addition, functions 94a and 94b that load the input data a[i] and b[i] from external memories 2a and 2b respectively into buffers 33a and 33b are configured using mainly PE 21.1 and PE 21.2 by the fourth configuration information 63d. Also, a function 95 that stores the output data z[i] into an external memory 2z is configured using mainly PE 21.5 by the fifth configuration information 63e. Since the external memory 2 is accessed via the BSU 36 after arbitration, the external addresses generated in the PE 21.1, PE 21.2 and the PE 21.5 are supplied to the BSU 36.

As shown in FIG. 10, in the implementation by the hardware information generated by the present invention, instead of having control carried out by a sequencer based on a single loop counter, control is carried out by many address counters with a simple construction. To arrange the large number of address counters, hardware resources are used. However, the individual address counters can be devices with limited functioning, and can be implemented as dedicated PE 21a, which improves the packing density. In addition, it is possible to arrange such PE 21a next to the buffers 33a, 33b and 34a used for input and output, and it is also possible to distribute and arrange the address counters for accessing the external memories 2a, 2b, and 2z at positions that facilitate the outputting of addresses to the BSU 36. This limits the wiring resources used for supplying addresses, which means that more wiring resources can be assigned to the construction of data paths.

In particular, the effect of the present invention is especially great when data is subjected to pipeline processing by the data path 91. As shown in FIG. 9, for a data path 82 that does not construct a pipeline, it may be quite easy to control a data path and to manage input and output data with a single counter. However, if the algorithm inside a loop is complex, timing closure cannot be achieved without using a data flow-type path that uses tokens or constructing a data path that carries out pipeline processing. In addition, pipeline processing is favorable for improving the processing performance of a data path, in such case it is not possible to collectively manage input data and output data with the same index and the sequencer becomes complex. With the hardware information according to the present invention, split and distributed address counters are fundamentally configured, so that implementation of pipeline in the matrix 10 can be carried out without being affected by the complexity of the algorithm of a loop process.

There are cases where a loop index is used in the data path 91 implemented on the matrix 10. A counter for the loop index can be arranged near the PE 21 that uses the loop index for minimizing the amount of wiring resources used. However, if many PE 21 are required to construct a loop counter, it is possible to use a remaining PE 21a that is special for address generation as the loop counter. If a PE 21a cannot be spared, it is possible to supply the output of the address generating PE 21a for processing the data path 91 to some PE 21 for calculating the loop index.

In the example shown in FIG. 10, the buffers 34 and 35 for use as a cache provided outside the matrix 10 are used as a storage region of data of a loop process. By arranging PE 21 of different types that function as a RAM inside the matrix, it is also possible to form a data path for loop processing that is closed inside the matrix 10.

When the buffers 33a, 33b, and 34a are used as a cache memory for the external memories 2a, 2b, and 2z, the external memories and buffers are connected via the BSU 36, so that even if the amount of data transferred in a unit of time becomes large, it is difficult to keep an accesses between a buffer and an external memory in occupying state. The buffers 33a, 33b and 34a in the present embodiment are dual-bank memories and can be used as double buffered type memories, so that it is possible to exchange data with an external memory coordinating with swapping the input side and output side. Accordingly, even when the array size of the input variables, the input data a[i] or b[i], is large, the overheads of data inputs and outputs can be reduced and a sufficient processing speed can be maintained by a loop process that is converted into an input/output type data path.

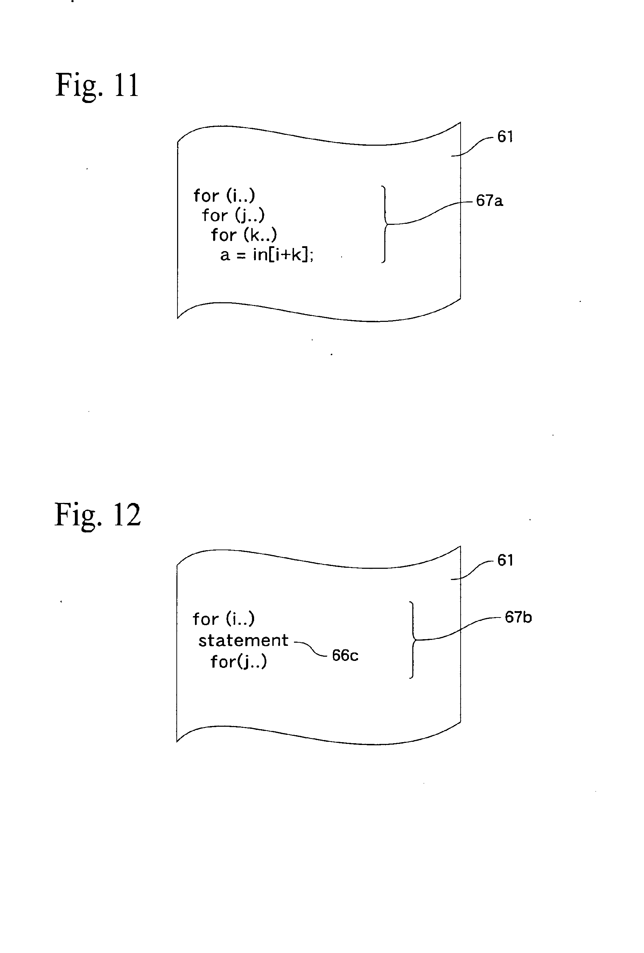

The method of generating hardware information according to the present invention is suited to optimizing complex loop processes and to realizing such processes with a simple construction. For example, for an algorithm 67a, such as that shown in FIG. 11, that includes multiple loop processing, it is possible to carry out processing having provided multiple buffers and multiple address counters. However, if an index with a multi-layered construction is a continuous data array, the multiple buffers can be merged into a single buffer and the multiple address counters can be merged into a single counter so as to information for controlling the multiple loop can be included in such single common or combined address counter. Accordingly, it is possible to merge a multiple loop into a single loop that is executed by a simple arrangement. Even in the case where the data array is non-continuous, by combining the PE 21a for issuing addresses and the PE 21b for logical operations it is possible to issue addresses suited to processing the multiple loop and to merge the multiple loop into a single loop.

The algorithm 67b shown in FIG. 12 is a multiple loop includes a statement 66c in the multiple loop but the statement 66c is written aside from the inner loop. In this case, by including a configuration for executing process of the outer statement 66c into the configuration of a data path for carrying out the processing of the innermost loop together with the condition of executing appropriate timing, it is possible to simplify the multiple loop. Accordingly, in the same way as described above, it is possible to merge the multiple loop into a single loop process that is implemented in the matrix 10.

Although the present invention has been described above by way of the PU 1 equipped with a reconfigurable region in which a plurality of PE are arranged in a matrix, the hardware to which the present invention can be applied is not limited to such. The present invention can also favorably implement loop processing in various types of reconfigurable hardware in which a plurality of PE, which have the same construction and are equipped with an ALU or an equivalent processing function, are connected by a suitable network. In addition, the present invention can be applied to an FPGA or to a special-purpose circuit.

## Claims

1. A method for generating hardware information for executing a first program that includes a first algorithm that repeats a first process, the method comprising generation of:
(a) first configuration information for generating output data produced by executing the first process on input data;
(b) second configuration information for executing a process that loads the input data from a first memory using a first address counter; and
(c) third configuration information for executing a process that stores the output data in a second memory using a second address counter.

2. A method according to Claim 1, wherein the hardware information is used for changing at least part of a configuration of an integrated circuit device equipped with a reconfigurable region.

3. A method according to Claim 2, wherein the reconfigurable region includes a plurality of processing elements and the first configuration information includes information for configuring a pipeline using at least some of the plurality of processing elements.

4. A method according to Claim 3, wherein the second configuration information and the third configuration information include information for configuring the first address counter and the second address counter respectively using at least some of the plurality of processing elements.

5. A method according to Claim 3, wherein the plurality of processing elements include a special-purpose element equipped with an address generating circuit and suited to the process that loads and/or the process that stores, and the second configuration information and the third configuration information include information for configuring the first address counter and the second address counter respectively so as to include the special-purpose element.

6. A method according to Claim 1, wherein the first memory and the second memory are internal buffers of an integrated circuit device, the method further comprising generation of:
(d) fourth configuration information for executing a process that loads the input data from an external memory into the first memory using a third address counter; and
(e) fifth configuration information for executing a process that stores the output data in the external memory from the second memory using a fourth address counter.

7. A method according to Claim 6,
wherein the first memory and the second memory are a double buffered type,
the fourth configuration information includes configuration information for realizing a process that loads the input data coordinating with swapping of the first memory, and
the fifth configuration information includes configuration information for realizing a process that stores the output data coordinating with swapping of the second memory.

8. A method according to Claim 1,
wherein the first configuration information includes configuration information that realizes a process that generates a parameter based on a value of the first address counter and/or a value of the second address counter.

9. A method according to Claim 1,
wherein the first program includes a second algorithm that repeats a process including the first algorithm, and
the second configuration information and the third configuration information include configuration information for realizing a process including the second algorithm.

10. A method according to Claim 9,
wherein the first configuration information includes configuration information for executing, at appropriate timing, a process aside from the first process and included in the second algorithm.

11. A recording medium storing hardware information that is capable of changing at least part of configuration of an integrated circuit device equipped with a reconfigurable region,
wherein to execute a first algorithm that repeats a first process, the hardware information comprises:
(a) first configuration information for generating output data produced by executing the first process on input data;
(b) second configuration information for executing a process that loads the input data from a first memory using a first address counter; and
(c) third configuration information for executing a process that stores the output data in a second memory using a second address counter.

12. A recording medium according to Claim 11,
wherein the first memory and the second memory are internal buffers of the integrated circuit device and the hardware information further comprises:
(d) fourth configuration information for executing a process that loads the input data from an external memory into the first memory using a third address counter; and
(e) fifth configuration information for executing a process that stores the output data in the external memory from the second memory using a fourth address counter.

13. A recording medium according to Claim 12,
wherein the first memory and the second memory are a double buffered type,
the fourth configuration information includes configuration information for realizing a process that loads the input data coordinating with swapping of the first memory, and
the fifth configuration information includes configuration information for realizing a process that stores the output data coordinating with swapping of the second memory.

14. A recording medium according to Claim 11,
wherein to execute a second algorithm that repeats processing including the first algorithm, the second configuration information and the third configuration information include configuration information that realizes a process including the second algorithm.

15. A recording medium according to Claim 14,
wherein the first configuration information includes configuration information for executing, at appropriate timing, a process aside from the first process and included in the second algorithm.

16. A program product for having a computer execute a process that generates hardware information for executing a first program including a first algorithm that repeats a first process, the hardware information comprising:
(a) first configuration information for generating output data produced by executing the first process on input data;
(b) second configuration information for executing a process that loads the input data from a first memory using a first address counter; and
(c) third configuration information for executing a process that stores the output data in a second memory using a second address counter.

17. A program product according to Claim 16,
wherein the hardware information changes at least part of an integrated circuit device equipped with a reconfigurable region.

18. A program product according to Claim 16,
wherein the first memory and the second memory are internal buffers of an integrated circuit device and the hardware information further comprises:
(d) fourth configuration information for executing a process that loads the input data from an external memory into the first memory using a third address counter; and
(e) fifth configuration information for executing a process that stores the output data in the external memory from the second memory using a fourth address counter.

19. A program product according to Claim 18,
wherein the first memory and the second memory are a double buffered type,
the fourth configuration information includes configuration information for realizing a process that loads the input data coordinating with swapping of the first memory, and
the fifth configuration information includes configuration information for realizing a process that stores the output data coordinating with swapping of the second memory.

20. A compiler comprising means for generating hardware information including configuration information for executing a first program including a first algorithm that repeats a first process, the configuration information comprising:
(a) first configuration information for generating output data produced by executing the first process on input data;
(b) second configuration information for executing a process that loads the input data from a first memory using a first address counter; and
(c) third configuration information for executing a process that stores the output data in a second memory using a second address counter.
